# EUROPEAN PATENT APPLICATION

(11) **EP 4 580 049 A1**
(43) Date of publication of application: **02.07.2025**
(21) Application number: 23220444.6
(22) Date of filing: 28.12.2023
(51) Int. Cl.: H03F 1/02, H03F 3/181, H03F 3/68

(54) **AUDIO AMPLIFIER CIRCUIT WITH POWER BALANCING SYSTEM**

(71) Applicant: Goodix Technology (HK) Company Limited, Sheung Shui (HK)
(72) Inventor: Schuurmans, Han Martijn, 6537 TL Nijmegen (NL); Krabbenborg, Bernardus Henricus, 6537 TL Nijmegen (NL); Jorritsma, Fré Jorrit, 6537 TL Nijmegen (NL)
(74) Representative: Nederlandsch Octrooibureau

(57) **Abstract**

An audio amplifier circuit comprising an amplifier; and a power balancing system comprising an interface circuit for connection to one or more other interface circuits of one or more other audio amplifier circuits, and a power terminal for connection to one or more other power terminals of the one or more other amplifier circuits thereby enabling power transfer between the audio amplifier circuit and the one or more other amplifier circuits.

## Description

### FIELD OF THE TECHNOLOGY

The present disclosure relates to an audio system and to an audio amplifier circuit comprising an amplifier; and a power balancing system comprising an interface circuit for connection to one or more other interface circuits of one or more other audio amplifier circuits, and a power terminal for connection to one or more other power terminals of the one or more other amplifier circuits thereby enabling power transfer between the audio amplifier circuit and the one or more other amplifier circuits.

### BACKGROUND

In modern mobile devices, such as tablets, mobile phones, and laptops, at least two audio amplifier circuits, each comprising at least one amplifier and one speaker, are used to produce stereo music. However, depending on the speaker in the audio device, amplifiers may have different power needs. Furthermore, depending on the audio signal, some speakers (e.g., micro speakers or sub-woofers) have a low efficiency, demanding full power that a battery for a mobile device is able to provide.

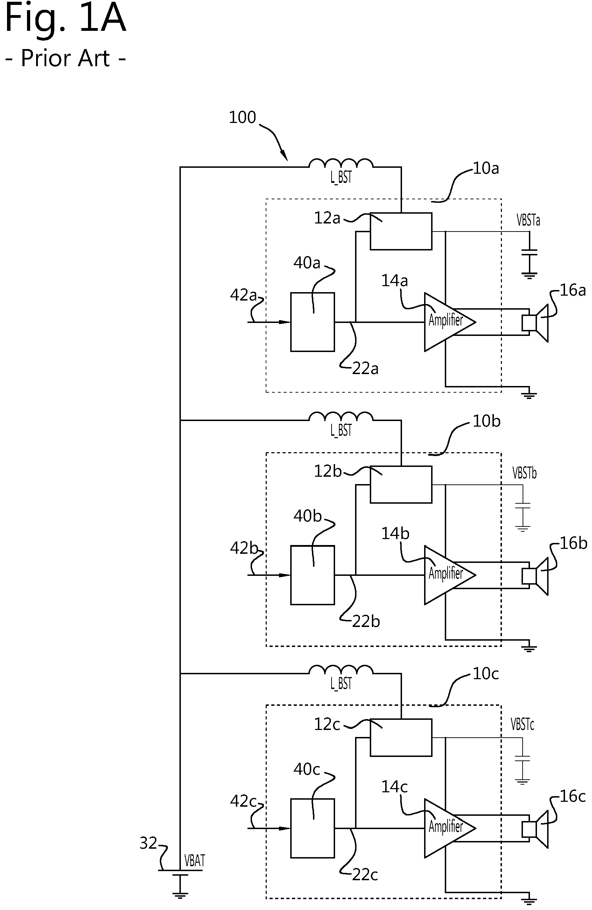

A typical configuration of an audio system is shown in Fig. 1A. In this example from the prior art, the audio system 100 comprises three audio amplifier circuits 10a, 10b and 10c each having a boost converter 12a, 12b, 12c, and each boost converter 12a, 12b, 12c providing power to an amplifier 14a, 14b, 14c. Each of the amplifiers 14a, 14b, 14c drives a load 16a, 16b, 16c (e.g., a speaker) and is configured to receive a digital audio signal 22a, 22b, 22c from an audio bus 40a, 40b, 40c via . Each audio bus 40a, 40b, 40c may receive an audio bus input 42a, 42b, 42c from e.g., an external circuit or component. The boost converters 12a, 12b, 12c boost an input voltage V_{BAT} from a source 32, for example a battery, to a higher boost voltage V_{BSTa}, V_{BSTb}, V_{BSTc}. Each of the boost converters 12a, 12b, 12c have a peak boosting value V_{BSTMAX}. To achieve high power for the speakers 16a, 16b, 16c (up to 7W), typically boost converters 12a, 12b, 12c supply of at least 12V connected to 3.7V Li-ion batteries as a source 32. This means that the current drawn from the battery 32 is multiplied by a factor of 12/3.7 to meet the power requirements of the speakers 16a, 16b, 16c. Thus, the peak current required from the battery 32 can reach up to 5A when a single amplifier 14 operates at full source power. To prevent exceeding the battery's limit, the boost converters 12a, 12b, 12c usually incorporate a battery current control, limiting the battery current at 5A. However, when the maximum battery current is set to 5A, equal power distribution among the amplifiers 14a, 14b, 14c becomes impractical because each amplifier can only receive a maximum current of 1.67A, significantly lower than the available 5A, that is, the maximum power output is *Poutₘₐₓ* = (*I_{BAT}*/3)² *· V_{BAT}.* This limitation poses a challenge when different amplifiers require varying power levels. Thus, mobile audio systems may require a way to balance the power demanded by the speakers.

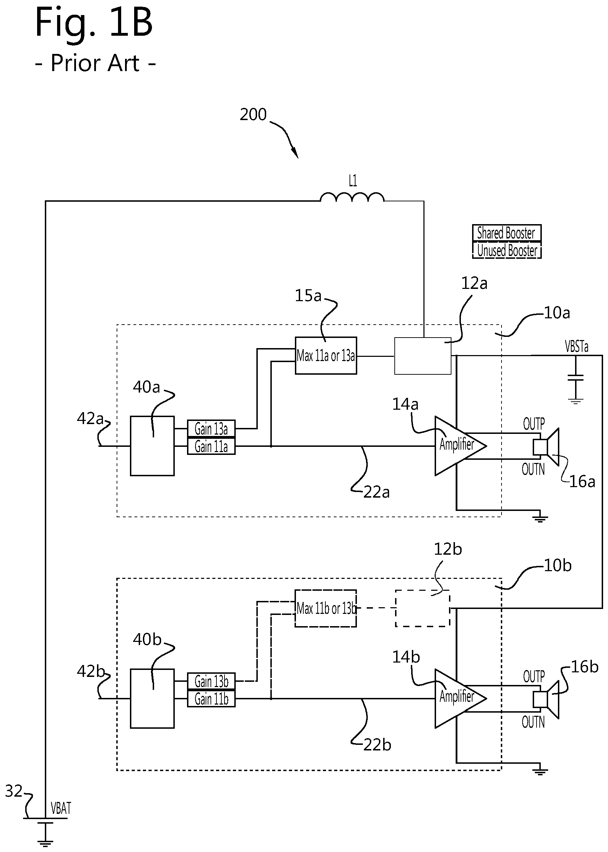

A current solution involves a shared booster, as depicted in the audio system 200 of Fig. 1B. Each amplifier 14a, 14b has a primary and secondary gain 11, 13, that are set depending on the respective speaker 16a, 16b, 16c characteristics. The first boost converter 12a receives a maximum gain between the primary and secondary gain 11a, 13a of the first amplifier 14a via a first maximum detector 15a. When the second amplifier 14b requires a high power, the secondary gain 13a incoming to the first maximum detector 13a is made equal to the primary gain 11b of the second amplifier 14b. In this manner, the first maximum detector 15a sets the first boost converter 12a as a shared booster to boost to the power that the second amplifier 14b needs. In this approach, the first boost converter 12a can provide full power to the first and/or second amplifier 14a, 14b, while a second boost converter 12b is not used. When the first boost converter 12a is set as shared booster, the secondary gain 13b of the second amplifier 14b is not utilized and therefore irrelevant. Conversely, for the first boost converter 12a, the primary gain 11b from the second amplifier 14b is crucial and preferably matches of that of the first amplifier 14a to balance the power from the source 32 between the two amplifiers 14a, 14b. However, this method has some drawbacks. It requires a large coil L1 in the first boost converter 12a to handle the high load, and it is limited to supporting only two boost converters. This limitation arises because the first boost converter 12a (shared booster) requires the primary gain 11b from the second amplifier 14b to determine the maximum boosting power and supply full power from the source 32 to the second amplifier 14b. Hence, adding more boost converters becomes impractical.

Alternatively, an automatic master-slave current-sharing solution involves using diodes between the output of the boost converters and a Share Bus. The boost converter with the highest output current can forward-bias its diode, thereby driving the Share Bus with the highest output current. The other boost converters, initially providing lower output power, would utilize the Share Bus as an input to adjust their output power according to the highest current being delivered in the Share bus. However, in the automatic master-slave current-sharing solution, the forward drop of the diode of the boost converter with the highest output current increases the voltage error between among boost converters.

In another alternative solution the boost converter are connected to an external controller that receives and processes the power from all boost converters. The controller provides a signal to each boost converter and adjusts accordingly control signals to balance the output power among the boost converters. Although this solution can achieve higher accuracy, it requires a more complicated circuit design and a relatively high cost.

It would be advantageous to provide an improved power balancing system that allow boost converters of several audio amplifier circuits to provide power to one or more amplifiers in a shared way that at least partially overcomes some of the inconveniences of the prior art and that can meet the power needs of the amplifiers.

### SUMMARY

According to a first aspect, it is provided an audio amplifier circuit comprising an amplifier; and a power balancing system, comprising an interface circuit for connection to one or more other interface circuits of one or more other audio amplifier circuits, and a power terminal for connection to one or more other power terminals of the one or more other audio amplifier circuits thereby enabling power transfer between the audio amplifier circuit and the one or more other amplifier circuits, the power balancing system configured to receive a signal providing an indicating of a target boosting power, wherein the target boosting power is determined based on power needs of the amplifier, and obtain, at the interface circuit, a maximum signal providing an indication of a maximum boosting power among the signal and one or more other signals providing an indication of target boosting powers corresponding respectively to the one or more other audio amplifier circuits, wherein each of the one or more other amplifier circuits comprises other amplifier, and each of the one or more other target boosting powers is respectively determined based on power needs of the other amplifier of the corresponding one or more other audio amplifier circuits; wherein the audio amplifier circuit and/or at least one of the one or more other audio amplifier circuits comprises a boost converter to be adjusted with the maximum signal to deliver the maximum boosting power.

The power balancing system introduced in this disclosure effectively enables power distribution and load sharing in an audio system having at least one boost converter and multiple amplifiers in different audio amplifier circuits. In a first scenario where the amplifier or one of the other amplifiers demands power, and the corresponding audio amplifier circuit does not include a boost converter, the power balancing system obtains the maximum signal indicating the maximum boosting power (which can represent to the target boosting power demanded by the amplifier) and adjusts the other boost converter in the other amplifier circuit(s) such that each other boost converter supplies the maximum boosting power to the amplifier by providing the maximum signal. In a second scenario in which two boost converters are present, for example in the audio amplifier circuit and at least one in the other amplifier circuits, and the amplifier or other amplifier demands a target boosting power exceeding a peak boosting power value of its corresponding boost converter, the power balancing system obtains the maximum signal indicating the maximum boosting power (which will correspond to the power demanded by the amplifier or the other amplifier) and adjusts the boost converter and/or other boost converters to supply the maximum boosting power by providing the maximum signal. In this way, the boost converter and the other boost converters operate together at the same level, effectively achieving load sharing of the amplifier demanding power exceeding a peak boosting power value of its corresponding boost converter. The power balancing system offers the advantage that it eliminates the limitation on the number of boost converters in an audio system comprising multiple audio amplifier circuits, accommodating multiple amplifiers connected to multiple speakers with different power requirements. This flexibility allows for a scalable power balancing system that can adapt to various audio setups. Therefore, the power balancing system facilitates the management of a larger number of connected audio amplifier circuits having amplifiers at least one boost converter compared to existing solutions found in prior art.

If the audio amplifier circuit comprises a boost converter, the boost converter may be configured to deliver power to the amplifier and to the power terminal, and the power balancing system may be further configured to transfer power from the boost converter to the one or more other amplifier circuits through the power terminal; if one or more of the other audio amplifier circuits comprises other boost converter, each of the other boost converters may be configured to deliver power to the other amplifier and the other power terminal of the corresponding other audio amplifier circuit, and the power balancing system may be further configured to receive power from the one or more of the other audio amplifier circuits comprising other boost converter, through the power terminal. This enables the audio amplifier circuit to also provide power to the amplifier and to one or more of the other audio amplifier circuits and allows the power terminal to have a bidirectional function to respectively receive, or transfer power from or to the other audio amplifier circuits. This provides efficient and flexible power distribution when the boost converter is in either one or both the audio amplifier circuit and one or more other audio amplifier circuits. Another advantage of having the boost converter directly connected to the amplifier within the audio amplifier circuit is that in situations where neither the amplifier nor one of the other amplifiers demands power exceeding a peak boosting power value, the boost converter can operate independently, delivering the boosting power only to its corresponding amplifier in the same audio amplifier circuit. This enhances energy efficiency as the power balancing system avoids unnecessary power consumption. The boost converter can precisely supply power to the amplifier without relying on power transfer from other audio amplifier circuits. The skilled person will understand that various scenarios are available due to the flexibility of connecting multiple audio amplifier circuits with and without boost converter. An advantage of making the boost converter and/or the other boost converters to operate at the same level is that the converters' power requirement may be reduced, which reduces the size and cost of each boost converter in each audio amplifier circuit resulting in a more compact and affordable audio system.

When the audio amplifier circuit comprises a boost converter, the audio amplifier circuit may further comprise a power input connected to a power source through a booster inductor, and when one or more of the other audio amplifier circuits comprises other boost converter, each of these other audio amplifier circuits may further comprise other power input connected to the power source through other booster inductor, and the power source may be configured for supplying power to the audio amplifier circuit and the other audio amplifier circuits and phase shifts may be incorporated between the boost converter and the other boost converters to achieve low ripple current.

The power input enables the use of a single power source for the boost converter in the audio amplifier circuit and the other boost converters in the other audio amplifier circuit, which facilitates the implementation of an audio system with multiple boost converters, simplifying the audio system design. Furthermore, this enables for a parallel connection between the boost converter output and other boost converters with respect to the power source.

If the audio amplifier circuit comprises a boost converter, the boost converter may include an inductor and capacitor; and if one or more of the other audio amplifier circuits comprises other boost converter, each of the other boost converters may respectively include other inductor and other capacitor, wherein values of the inductor and the other inductors and values of the capacitor and the other capacitors may be nearly identical among the boost converter and the other boost converters such that the power supplied by the power source is equally distributed among the boost converter and the other boost converters. This also contributes to share the load among the boost converters in the audio amplifier circuit and/or the other amplifier circuits. As the load is shared more equally due to nearly identical among the boost converter and the other boost converters, the resistance of each individual boost converter's inductor can be increased, allowing for smaller and potentially more cost-effective inductors. Furthermore, having nearly the same values in the inductor and capacitor in the boost converter and the other boost converters allows for an efficient audio system in which multiple audio amplifier circuits may be connected in parallel. Multiple boost converters having nearly the same values in the inductor and capacitor and connected in parallel offers several advantages. Firstly, resistive losses are reduced, resulting in improved efficiency. Additionally, the saturation current, which indicates the maximum current the inductor can handle before saturating, can be decreased. This results in improved size efficiency and enhances overall performance compared to utilizing a single larger boost converter. Additionally, the parallel configuration is flexible in accommodating additional boost converters of other audio amplifier circuits to implement redundancy, ensuring a highly reliable audio system. Redundancy, in this context, refers to having more boost converters than required to meet the total power demand. This advantageous redundancy feature ensures that even if one of the boost converters fails, the audio system can still deliver the same amount of power seamlessly. Additionally, multiple boost converters having nearly the same values in the inductor and capacitor and connected in parallel further facilitates efficient load sharing among the boost converter and the other boost converters, as none of them may need to work more than the others based on the load of a high-demand amplifier.

The target boosting power may be further determined based on a digital audio signal to be amplified by the amplifier, and each of the other target boosting powers may be further determined based on other digital audio signal to be amplified by the other amplifier of the corresponding other audio amplifier circuit. Advantageously, this further enhances energy efficiency as the boost converter and the other boost converters may reduce their target boosting power when the digital audio signal is low or absent.

The audio amplifier circuit may further comprise an audio bus configured for conveying the digital audio signal to be amplified from an external processor to the amplifier and to the boost control circuit, each of the other audio amplifier circuits may comprise other audio bus configured for conveying the other digital audio signal to be amplified from the external processor, or other external processor, to the other amplifier and to the other boost control circuit. The audio amplifier circuit and the other audio amplifier circuits may respectively receive the audio digital signal and the other digital audio signal from a common external processor responsible for generating stereo or multi-channel audio, requiring the at least two audio amplifier circuits. Depending on the audio system design, these circuits can also receive signals from multiple external processors.

The audio amplifier circuit may further comprise a speaker connected to the amplifier, and the amplifier having feedback to adapt to the load of the speaker; the one or more other audio amplifier circuits each may comprise other speaker respectively connected to the other amplifier of the corresponding other audio amplifier circuit, with the another amplifier having feedback to adapt to the load of the respective other speaker. By having an amplifier dedicated to each speaker, the amplifier's specifications can precisely match the requirements of the specific speaker. This is particularly advantageous if an amplifier is connected to a boost converter delivering higher power than demanded by the amplifier due to the speaker. The speakers may be contained in the audio amplifier circuit or may be outside of it.

The signal providing an indication of the target boosting power may be a digital set-point representing the target boosting power. The audio amplifier circuit may further comprise a boost control circuit configured for generating the digital set-point from the digital audio signal, and to provide the digital set-point to the power balancing system; each of the other audio amplifier circuits may further comprise a boost control circuit each configured for generating the other digital set-point from the other digital audio signal and to provide the other digital set-point to the power balancing system. The boost control circuit is a dedicated circuit that provides the digital set-point precisely according to the digital audio signal. This is particularly useful when the audio amplifier circuit or the other audio amplifier circuits do not comprise a boost converter, the boost control circuit generates the digital set-point to enable its transfer to, or detection by, other audio amplifier circuits.

The interface circuit of the power balancing system may comprise a transistor with an Open Drain Output. In a first example, the interface circuit comprises a Digital to PWM converter configured for converting the digital set-point to a PWM signal and a transistor with an Open Drain Output, wherein the Gate terminal of the transistor receives the PWM signal and the Drain terminal is connected to an interface line and to the ground via a resistor; and wherein each of the other audio amplifier circuits comprises other Digital to PWM converter configured for converting the other digital set-point to other PWM signal, and other transistor with other Open Drain Output, wherein the Gate terminal of the other transistor receives the other PWM signal and the Drain terminal is connected to the interface line and to the ground via other resistor; wherein the power balancing system obtains the maximum boosting power by detecting, at the interface circuit, a highest PWM duty-cycle signal among the PWM signal and the other PWM signals; wherein if the audio amplifier circuit comprises a boost converter, the power balancing system further comprises a PWM to Digital converter configured for converting the highest PWM duty-cycle signal to the maximum digital set-point representing the maximum boosting power. The interface line allows the interface circuit and other interface circuits to connect to each other. Advantageously, the Open Drain Output enhances synchrony and minimum delay in the detection of the maximum boosting power and adjustment of the boost converter, due to the analogue nature of the Open Drain Output. Consequently, the Open Drain Output leads to cost and energy savings in the audio system. PWM signals facilitate the functioning of the Open Drain Output from digital set-points provided by e.g., a processor in the audio system. Furthermore, PWM signals enhance the accuracy of the boost converters' output particularly when the target boosting power is low. PWM signals facilitate the functioning of the Open Drain Output from digital set-points provided by e.g., a processor in the audio system.. Furthermore, PWM signals enhance the accuracy of the boost converters' output particularly when the target boosting power is low. Optionally, the Source terminal of the transistor is connected to the working voltage of the IC (VDD) or to the ground GND.

In another implementation of the power balancing system, the interface circuit may further comprise a Digital to Analogue Converter configured for converting the digital set-point to an analogue signal, an Op-Amp circuit configured for receiving the analogue signal and outputting an amplified analogue signal, and a transistor with an Open Drain Output wherein the Gate terminal of the transistor receives the analogue signal and the Drain terminal is connected to the interface line and to the ground via a resistor; wherein each of the other audio amplifier circuits comprises other Digital to Analogue Converter configured for converting the other digital set-point to other analogue signal, other Op-Amp circuit configured for receiving the other analogue signal and outputting an amplified analogue signal, and other transistor with an Open Drain Output, wherein the Gate terminal of the other transistor, receives the other analogue signal and the Drain terminal is connected to the interface line and to the ground via other resistor; wherein the power balancing system obtains the maximum boosting power by detecting, at the interface circuit, a maximum analogue signal among the analogue signal and the other analogue signals; wherein if the audio amplifier circuit comprises a boost converter, the power balancing system further comprises an Analogue to Digital Converter configured for converting the maximum analogue signal to the digital maximum digital set-point representing the maximum boosting power. Advantageously, this is an implementation of voltage follower that can increase (source) the voltage but cannot lower (sink) the voltage on the interface line. It can be suitable when PWM signals may are incompatible or less desirable in the audio system. Alternative ways maybe used to obtain the maximum digital set-point. For example, using active voltage and/or current sensing of each boost converter and comparators to recognize the maximum boosting power. This can be by means of a feedback loop circuitry that measures the amplifiers power needs and controls the boosting power of the boost converters accordingly. However active sensing may involve a delay. Each of the transistor and/or the other transistor may be a MOSFET (metal-oxide-semiconductor field-effect transistor). Alternatively, a NPN BJT (bipolar junction transistor) may be used. MOSFETs are preferable due to their lower on-state voltage drop and low conduction losses compared to BJTs. Alternatively, the interface circuit of the power balancing system may comprise a processor configured as a maximum digital set-point detector to receive the digital set-point and other digital set-points and to determine the maximum digital set-point representing the maximum boosting power. The maximum digital set-point detector can determine the maximum boosting power and route digital signals to the boost converter and/or other boost converters, ensuring precise synchronization. The digital set-point is sent to all connected audio amplifier circuits via a separate dedicated Time Division Multiplexed (TDM) slot, next to audio stream slots The PWM signal frequency may be the same as FS frequency. Furthermore, this arrangement offers a high flexibility as it allows for selective control of many boost converters. However, it may also involve more cost and delay. Alternatively, the maximum digital set-point detectors may be implemented as a series of comparators, or other analogue or digital solutions known in the art may be used.

The boost converter and the other boost converters, if present, may be step-up DC-DC (Direct Current to Direct current) converters able to work in discontinuous mode, when an output voltage of the step-up DC-DC converter reaches or exceeds a voltage related to the target boosting power, the step-up DC-DC converters stop switching resulting in zero or negative current flowing through the inductor in the step-up DC-DC converter and energy stored in the inductor is gradually dissipated. Step-up DC-DC converters are suitable to increase the amount of power harvested from the power source. Alternatively, DC-DC boost converters may be charging pump converters or switched capacitor converters if the typical power requirements of the audio system are generally low. Yet, DC-DC converters are preferable due to their higher efficiency, voltage range and compact size.

The amplifier and the other amplifiers may be class-D switching amplifiers, which have high-efficiency and can be used with a wide range of speakers and loads, including both high-impedance speakers (such as traditional passive speakers) and low-impedance speakers (such as subwoofers).

According to another aspect of the invention an audio system is provided comprising at least two audio amplifier circuits according to the first aspect of the invention, wherein each audio amplifier circuit comprises at least one amplifier requiring a target boosting power, wherein at least one audio amplifier circuit comprises a boost converter and wherein the power balancing system in the audio amplifier circuit with the boost converter is configured to obtain a maximum boosting power among the target boosting powers, and adjust the boost converter to provide the maximum boosting power.

### SHORT DESCRIPTION OF DRAWINGS

In the following, aspects of the disclosure will be elucidated by means of examples, with reference to the drawings in which:
Fig. 1A and 1B show known audio systems.
Fig. 2A shows a schematic diagram of audio system with two audio amplifier circuits according to the present disclosure, wherein one of the audio amplifier circuits comprises a boost converter.
Fig. 2B shows a schematic diagram of an alternative audio system with two audio amplifier circuits according to the present disclosure, wherein each of the two audio amplifier circuits comprises a boost converter.
Fig. 3 shows a schematic diagram illustrating a first exemplary implementation of interface circuits in the power balancing system in the audio system of Fig. 2A.
Fig. 4 shows a schematic diagram illustrating a second exemplary implementation of the interface circuit in the power balancing system in the audio system of Fig. 2A.
Fig. 5 shows a schematic diagram illustrating a third exemplary implementation of the power balancing system in an audio system.
Fig. 6 shows a schematic diagram illustrating a fourth exemplary implementation of the power balancing system in the audio system of Fig. 1B.

### DESCRIPTION OF EMBODIMENTS

Examples will now be described, by way of illustration only, with reference to the accompanying schematic drawings in which corresponding reference symbols indicate corresponding parts. In the drawings, like numerals designate like elements. Multiple instances of an element may each include separate letters appended to the reference number. For example, two instances of a particular element "112" may be labeled as "112a" and "112b".

The present disclosure examples provide an audio system with a power balancing system able to equally distribute power among multiple boost converters to effectively share the load from multiple amplifiers, resulting in a more scalable and compact load sharing solution for an audio system.

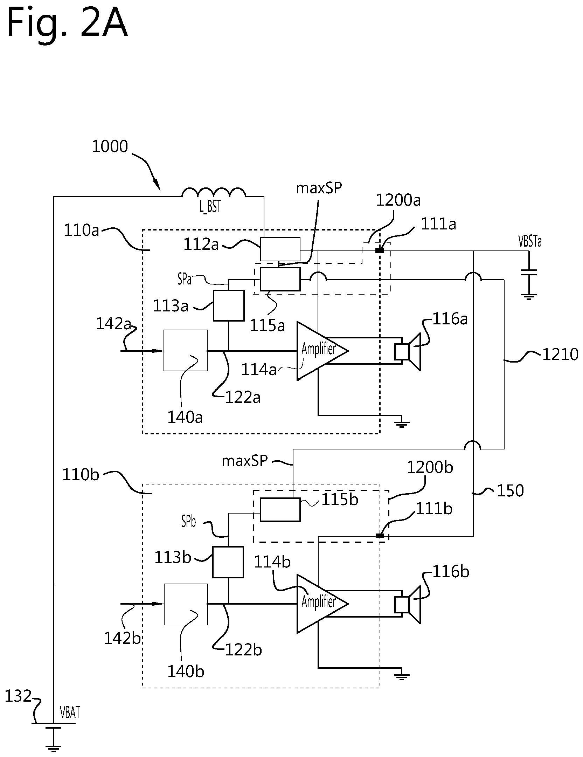

Fig. 2A shows a schematic diagram of an audio system 1000 according to the present disclosure. The audio system 1000 may be a regular printed circuit board PCB, e.g., having an epoxy or ceramic base, or a flexible printed circuit (FPC). In this example, the audio system 1000 comprises two audio amplifier circuits 110a, 110b each having an amplifier 114a, 114b. The first audio amplifier circuit comprises a boost converter 112a providing power to either one or both of the amplifiers 114a, 114b. The skilled person will understand that the minimum amount of boost converters in an audio system is one and that the depicted audio system 1000 may comprise more audio amplifier circuits each with or without boost converters. If more boost converterts are incorporated in the audio system they are preferably connected in parallel and to boost power to at least to one amplifier 114a, 114b. Each of the amplifiers 114a, 114b drives a load 116a, 116b (e.g., a speaker) and are configured to receive a digital audio signal 122a, 122b via an audio bus 140a, 140b. Each audio bus 140a, 140b receives an audio bus input 142a, 142b from an external circuit or component, such as an external processor managing one ore more audio amplifier circuits. The audio buses 140a, 140b are I²S (Inter-IC Sound) audio interfaces which can be used for efficiently connect audio amplifier circuits or other audio devices together. In the I2S audio buses 140a, 140b, the digital audio signal 122a, 122b is created through the audio bus input 142a, 142b comprising three main signals: Frame Select (FS), Bit Clock (BCK), and Data Input (DATAI). FS marks the start of a new audio frame, BCK controls the timing and pacing of data transmission, and DATAI carries the actual digital audio data. As the FS signal indicates the beginning of each frame, BCK governs the rate at which data bits are sent, and DATAI receives the synchronized digital audio information. Together, these signals ensure the precise and synchronized transfer of digital audio data between the external device and the audio amplifier circuits 110a, 110b.The boosting power of the boost converter 112a involves boosting an input voltage V_{BAT} from a source 132, for example a battery, to a higher boost voltage V_{BSTa} via a boost inductor L_{BST}.

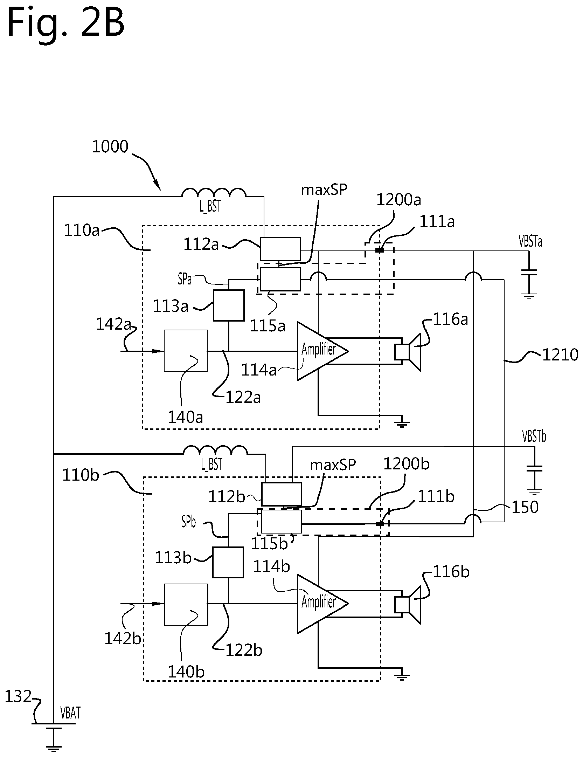

If more than one boost converter is used, as shown in Fig. 2B in which the second audio amplifier circuit 110b comprises a second boost converter 112b, the additional boost converter 112b may also connect to the same source 132 through other inductor L_{BST} and boost power to its own boost voltage V_{BSTb}. The boost converters 112a, 112b of Fig. 2A and 2B, and any other boost converter may have an adjustable peak boosting voltage V_{BSTMAX} and maximum current I_{MAX} harvested from the source 132. In that way, in an audio system with two or more boost converters, the power from the source 132 can be distributed between the boost converters. The value of the inductor L_{BST} may depend on the boosting power V_{BST} of each boost converter.

The audio amplifier circuits 110a, 110b in Figs. 2A and 2B comprise a boost control circuit 113a, 113b, providing a digital set-point SPa, SPb representing the target boosting power to each of the amplifiers 114a, 114b. The digital set-points SPa, SPb are signals providing an indication of the target boosting power and derived from the digital audio signal 122a, 122b to amplify and from power needs of the respective amplifiers 114a, 114b. For example, each amplifier 114a, 114b may be designed with different power needs according to the speaker 116a, 116b that they provide power thereto. The digital set-points SPa, SPb may be determined in different ways depending on the amplifier circuit and the digital audio signal. For instance, an amplitude-based method directly correlates the digital set-point with an audio signal's volume, for example, by mapping the digital audio signal to the digital set-point by a function relating the amplitude of the digital audio signal to the target boosting power in the boost converter's output. This function is typically linear such that the digital set-point SPa, SPb is proportional to the respective amplitude of the digital audio signal 122a, 122b. This may involve performing a digital-to-analog conversion to obtain a continuous analog representation of the digital audio signal. Optionally or additionally, a frequency-based method uses frequency content of the digital audio signal to determine the digital set-point, accommodating diverse power requirements associated with different frequencies. Alternatively, a dynamic range analysis may be used to include intensity and/or energy variability in the digital audio signal, ensuring that the boost converter can effectively handle peaks and lows of intensity and/or energy. Depending on the audio system, a combination of these methods may be used. The digital set-points SPa, SPb are generated by the a boost control circuit 113a, 113b from audio bus 140a, 140b connected to another circuit or element. The boosting voltage V_{BST} of each boost converter 112a and/or 112b, maybe defined based on the digital set-point SPa, SPb.

Although an audio system has minimally two amplifiers and one boost converter as shown in Fig. 2A, typically mobile devices have more than two amplifiers including left, right, and subwoofers, folding phones may have more. Tablets or PCs commonly have four amplifiers/speakers. Cars often feature up to ten amplifiers for enhanced audio performance. In a home theatre system, a minimum of three speakers (left, right, and centre) or four speakers (left, right, centre, and subwoofer) are typical, and additional satellite speakers may be added to create surround sound. Some speakers, such as sub-woofers may require full source power when the audio digital audio signal has relatively low frequencies. To overcome this demand, the amplifier circuits according to the present disclosure may further comprise a power balancing system 1200a, 1200b to enable power transfer from one or more boost converters to any of the amplifiers driving any speaker that could demand a high load. If the audio system comprises one boost converter 112a, as in Fig. 2A the power balancing system 1200a, 1200b in each audio amplifier circuit 1 10a, 110b enables power transfer from the boost converter 112a to any of the amplifiers 114a, 114b driving the speaker with the highest load. If the audio system comprises more than one boost converter, as in Fig. 2B, the power balancing system 1200a, 1200b allows the boosting powers V_{BSTa}, V_{BSTa} of the boost converters 112a, 112b to add up and to provide power to the amplifier in the audio amplifier circuit with the highest target boosting power (i.e., highest digital set-point), this further enables sharing of the high load between the boost converters 112a, 112b. It will be understood that the power balancing system may be used in other audio amplifier circuits with multiple amplifiers that are connected to multiple speakers.

In the audio amplifier circuits 110a, 110b in Figs. 2A and 2B, the power balancing system 1200a, 1200b comprises a power terminal 111a, 111b in each of the audio amplifier circuits 110a, 110b. The power terminals 111a, 111b are connected to each other by distribution line 150 which provides a common power line between to the amplifiers 114a, 114b. In Fig. 2A, the distribution line 150 allows power transfer from the boost converter 112a to any amplifier 114a, 114b. In Fig. 2B with more than one boost converter, the boost converters 112a, 112b are connected by distribution line 150, which further allows load sharing of any amplifier 114a, 114b between the boost converters 112a, 112b. In this parallel configuration shown in Fig. 2B, the boost converters 112a, 112b may have the same characteristics, thus having the same V_{BSTMAX}. In this manner the load is more easily shared and the source 132 power equally distributed. These characteristics may include at least an inductor and capacitor.

In some examples, the boost converters 112a, 112b are DC-DC converters known in the art. In this context, DC-DC converters are electronic circuits employing switching techniques, using power semiconductor devices such as transistors along with energy storage elements like inductors and/or capacitors, to efficiently step-up (boost) the input voltage to match the desired target boosting power.

The power balancing system 1200a, 1200b comprises interface circuits 115a, 115b in each of the audio amplifier circuits 110a, 110b. The interface circuits 115a, 115b are connected to each other through an interface line 1210. The interface circuits 115a, 115b have an input connected to the boost control circuits 113a, 113b to receive the respective digital set-point SPa, SPb. If any of the audio amplifier circuits 110a, 110b has a boost converter, such as the first audio amplifier circuit 110a in Fig. 2A and both audio amplifier circuits 110a, 110b in Fig. 2B, the interface circuits 115a, 115b further comprise an output to adjust the respective boost converter 112a, 112b by providing it with maximum digital set-point (max SP). Thus, a maximum boosting power is obtained at the interface circuits 115a, 115b by detecting the maximum digital set-point among the digital set-points SPa and SPb of the audio amplifier circuits 110a, 110b. If the audio system has one boost converter, as in Fig. 2A, then the boost converter 112a is adjusted to provide the maximum boosting power to the amplifier in the audio amplifier circuit (either 114a, or 114b) with the highest digital set-point. It is also possible that the boost converter 112a provides the maximum boosting power to both of the amplifiers 114a, 114b.

In general, the power balancing system is able to obtain the maximum digital set-point among the digital set-points representing the target boosting powers of multiple audio amplifier circuits and provide the maximum digital set-point to one boost converter to deliver the maximum boosting power. If more than one audio amplifier circuit comprises a boost converter, as in Fig. 2B, the power balancing system 1200a, 1200b obtains the maximum digital set-point among the audio amplifier circuits 110a, 110b and adjusts the digital set-point of each boost converter 112a, 112b to the maximum digital set-point. This will balance the power of the power source 132 among the boost converters and share the load that one or more amplifiers may need due to the speaker. In this way, each boost converter is fully operating, if one of the boost converters is required to deliver the maximum boosting power by having the maximum digital set-point in the respective audio amplifier circuit, all other boost converters will follow by providing the maximum boosting power and will contribute to the output power, until a maximum inductor current per boost converter is reached. In comparison to the prior art described with reference to Fig. 1A, the boost converters working together as in the example of Fig. 2B lead to 100% efficiency in the power output, i.e., *Poutₘₐₓ* = (*I_{BATmax}*) *· V_{BAT}.*

The power balancing system does not restrict the number of audio amplifier circuits, i.e., the number of boost converters and/or amplifiers in the audio system 1000. This is different from the audio system 100 of the prior art shown in Fig. 1A, in which the boost converters 12a, 12b, 12c do not work together, each of them receives a different digital set-point SPa, SPb, SPc, which are likely different between each other as they are independently connected to amplifiers 14a, 14b, 14c configured for different speakers 16a, 16b, 16c, and the audio amplifier circuits 10a, 10b, 10c, do not communicate with each other.

In examples using DC-DC converters, a discontinuous mode can provide a mechanism to regulate the output voltage of the boost converters more efficiently. When the output voltage of a DC-DC converter reaches the desired target boosting power or exceeds it, the DC-DC converter will stop switching resulting in zero or negative current flowing through the inductor and energy stored in the inductor will be gradually dissipated (current not sinking). This advantageously prevents any individual DC-DC converter from discharging or acting as a load on the shared boosting power or voltage V_{BST}. This mechanism holds even if there are minor deviations in the maximum digital set-point provided to the each of the DC-DC converter due to process/manufacturing variations, as these variations will not result in one DC-DC converter pulling current from other(s) DC-DC converter with a slightly maximum digital set-point.

In some examples, the amplifiers 114a, 114b are class-D switching amplifiers. Class D amplifiers offer high efficiency and compatibility with a wide range of speakers and loads. Furthermore, class-D switching amplifiers may have feedback. In this way, each amplifier receives 2 input voltages, its own feedback voltage determined by the load of the speaker, and the voltage from the boost converter(s), derived from the maximum boosting power if needed (not shown in Figures). The amplifier feedback allows it to compare and adapt its output based on the speaker load and the digital audio signal 122a, 122b, even if the power delivered by one or more boost converters is higher than needed. By continuously monitoring and adjusting the output, the feedback mechanism helps maintain the desired output characteristics and reduces distortion.

An example of the power balancing and load-sharing functionality of the power balancing system within an audio system composed of two audio amplifier circuits, where more than one audio amplifier circuit includes a boost converter, for example as in Fig. 2B, is described as follows:
A mobile audio system may have an audio amplifier circuit 110a connected to a subwoofer 116a such as a micro speaker for low frequencies and other audio amplifier circuit 110b connected to a satellite speaker 116b for mid and high frequencies. The amplifier 114a connected to the subwoofer will then require the most power. As the boosting power of each boost converter 112a, 112b is nearly the same (due to their equal characteristics), the current provided by the boost converters 112a, 112b is nearly equal. Thus, the parallel connection of the boost converters 112a, 112b facilitates power transfer from any boost converter 112a, 112b to any amplifier 114a, 114b through distribution line 150. While the amplifiers 114a, 114b operate independently, the boost converters 112a, 112b work collectively. In this way, when the amplifier 114a connected to the subwoofer 116a requires maximum source current e.g., 5A, the two boost converters 112a, 112b work together, each supplying a maximum of 2.5A, resulting in a total of 5A. Consequently, the subwoofer 116a receives sufficient power from the source 132 when necessary. In this example, the audio system can deliver a peak power of 20W (with a battery of 4V), which is substantially higher compared to the previous 7W power from the prior art example discussed previously with reference to Fig. 1A.

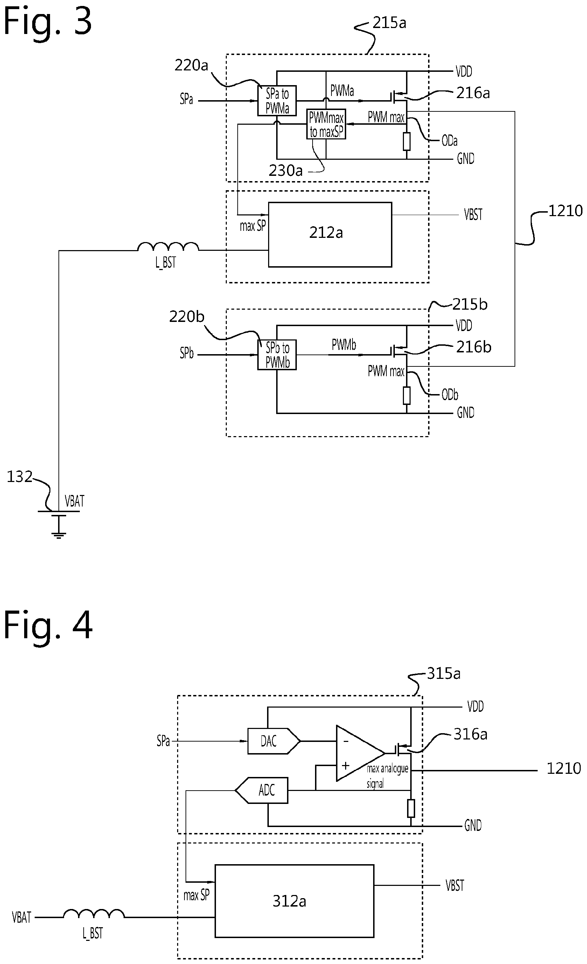

Fig. 3 shows a schematic diagram illustrating a first exemplary implementation of the interface circuit 215a, 215b in the power balancing system 1200a in the audio system 1000 of Fig. 2A. Features of the audio system 1000 that have already been described above with reference to Fig. 2A or Fig. 2B may also be present in Figures 3-6 and will not all be discussed again. For the description with reference to Figures 3-6, like features are designated with similar reference numerals preceded by 200, 300 and so on to distinguish the examples.

The implementation of the interface circuits 215a, 215b shown in Fig. 3 achieves a wired-OR logic connection. Each of the digital set-points SPa, SPb are delivered to the interface circuits 215a, 215b, by the boost control circuits 113a, 113b (not shown) and then converted into a Pulse Width Modulated (PWM) signals (PWMa, PWMb) by a PWM converter 220a, 220b, as the digital set-points SPa, SPb may be different from each other, the PWM signals (PWMa, PWMb) will have a different duty-cycle for representing their respective digital set-point SPa, SPb. For an audio system with two boost converters 112a, 112b, (Fig. 2B) the frequency of the BCK for each boost converter 112a, 112b, needs to be at least 32 times the FS frequency. By utilizing 5 bits, the digital set-points SPa, SPb can have 32 different values, allowing for duty-cycle variations from 0% to 100% in increments of 3.23%. If digital Class D amplifiers are used for amplifiers 114a, 114b, higher resolution can be achieved by utilizing the embedded Phase-Locked Loop (PLL). In the case of a Smart (class D) Amplifier, the PLL operates at a frequency of 4096 times the FS frequency, which translates to 196.6MHz. This higher frequency enables precise control of the digital set-points SPa, SPb with 256 levels (8 bits). Thus, a clock signal of 256 times the FS frequency is sufficient and readily available for any audio system application.

The PWM signal (PWMa, PWMb) in each interface circuit 215a, 215b is provided to the Gate of a transistor 216a, 216b, having an Open Drain Output (ODa, ODb), and with the Source terminal connected to the working voltage of the IC (VDD) or to the ground GND, which allows the transistor to act as a switch that can either connect to ground GND (low state) or disconnect (high state). The drain outputs of the transistors are interconnected using interface line 1210.

As an operation example, when the first transistor 216a receives a PWM signal (PWMa) with a duty-cycle that is higher than the duty-cycle than that of the PWM signal (PWMb) received in the second transistor 216b (i.e., it has a longer pulse width), its corresponding PWM signal in the ODa output will be in a high state for a longer duration. This will cause the combined PWM signals in the interface line 1210 (and the transistors' Drain Output ODa, ODb) to also be in a high state for that duration, irrespective of the second PWM signal (PWMb) or any other PWM signals of other audio amplifier circuits in the audio system. Conversely, in the second transistor 216b having a lower duty-cycle, the PWM signal (PWMb) in the Open Drain Output ODb will be in a high state for a shorter duration, resulting in a shorter contribution to the combined PWM signal in the interface line 1210 compared to the transistor 216a with the higher duty-cycle. As a result, the PWM signal with the highest duty-cycle overrules the PWM signal in the transistors' Drain Output 216a, 216b, effectively being the highest PWM duty-cycle signal obtained in the power balancing system. Thus, by connecting the Open Drain Outputs (ODa, ODb) together, the audio amplifier circuit with the highest duty-cycle takes precedence over the others, producing an OR-gate function, known as a wired-OR connection. In audio amplifier circuits with a boost converter (e.g., boost converter 112a in Fig. 2A), the highest PWM duty-cycle signal (PWM max) is converted to the maximum digital set-point (max SP) by a unit 230a (wherein the unit 230a is a RC type low-pass filter or other circuit known in the art) and provided to the boost converter 212a. If there are more boost converters available in an audio system in other audio amplifier circuits, the wired-OR connection ensures that all boost converters adopt the maximum digital set-point (max SP).

Fig. 4 shows a schematic diagram illustrating a second exemplary implementation of the interface circuit 315a in the power balancing system 1200a in the audio system 1000 of Fig. 2A. In this example, the wired-OR connection is achieved with an analogue signal. The digital set-point (SPa) is converted to the analogue signal, e.g., a voltage value, by a Digital to Analogue Converter DAC which output is followed in the transistor's 316a output if no power balancing is needed. Here, each digital set-point is converted in the analogue signal, e.g., voltage, by means of a voltage source VDD that only can source, but not sink. Meaning that this voltage VDD current direction is always out, not in. It will not reverse the current. In this way, the interface circuit which has the highest analogue signal will show up at the Open Drain Output of the transistor 316a and the interface line 1210. That is, when any other transistor circuit has a higher DAC output, the signal in the interface line 1210 rises to VDD. As a result, a maximum analogue signal is detected in the Drain terminal which is then provided to the boost converter 312a through an Analogue-Digital Converter (ADC) that converts the maximum analogue signal to the maximum digital set-point.

For a wired-OR connection with open-drain outputs, transistors with open-drain or open-collector outputs may be used, for example, N-channel MOSFETs or NPN bipolar junction transistors (BJTs). Figs. 2B, 3 and 4 show MOSFETs in which the Drain terminal is connected to the interface line 1210 (shared bus) and to the ground via a resistor. If BJTs are use, the Collector may be connected to the interface line 1210 and to the ground via a resistor.

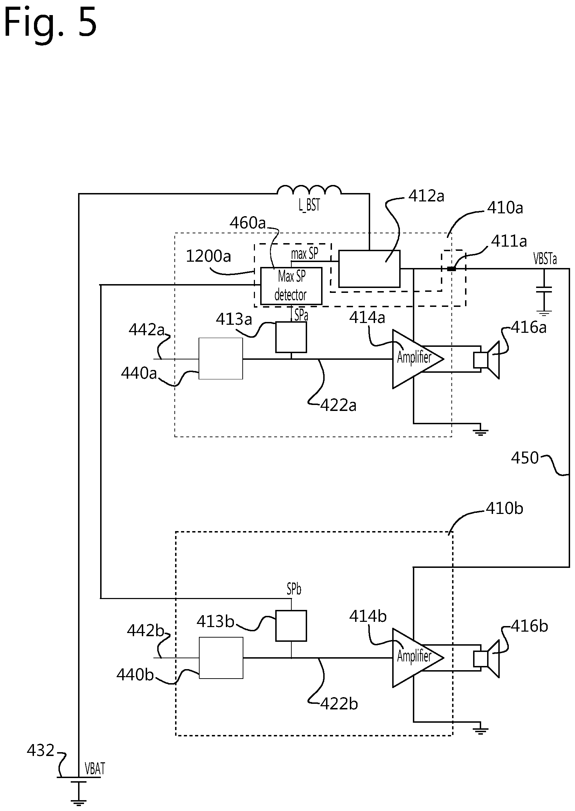

Fig. 5 shows a schematic diagram illustrating a third exemplary implementation of the power balancing system 1200a in an audio system. The power balancing system 1200a in the first audio amplifier circuit 410a comprises a maximum digital set-point detector 460a (Max SP detector) provided to the first boost converter 412a and configured for receiving the digital set-points SPa, SPb of both audio amplifier circuits 410a, 410b from their respective boost control circuit 413a, 413b to detect the maximum digital set-point and provide it to the first boost converter 412a. In the case that the second audio amplifier circuit 410b comprises a boost converter and a Maximum SP detector (not shown), after detecting the maximum digital set-point, each boost converter will get the maximum of the digital set-points, max SP, resulting in all boost converters boosting power to the same maximum level, which is needed by the amplifier (414a, 414b) with the highest load (i.e., speakers 416a, 416b). The max SP detector 460a may consist of a processor, digital comparators, or any other way known in the art.

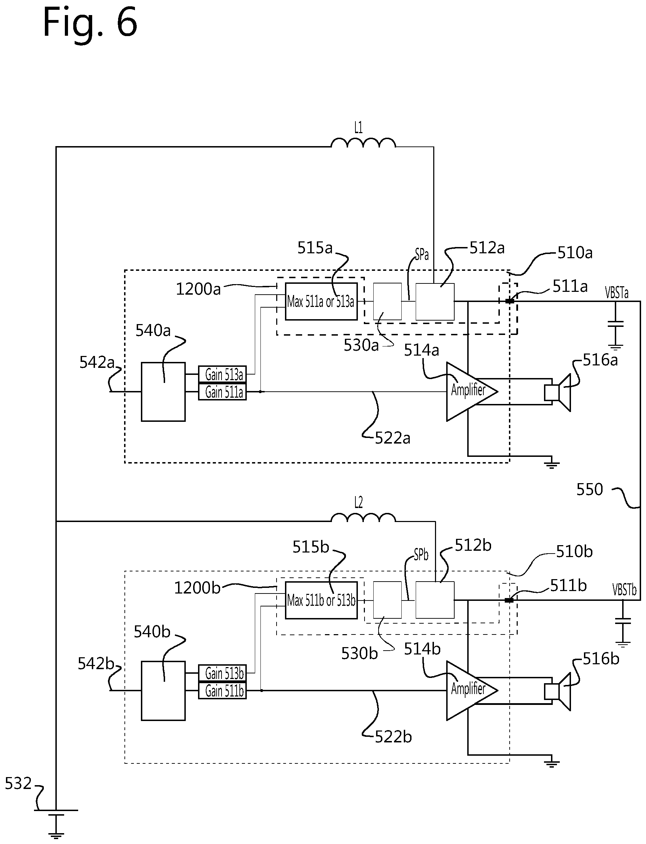

Fig. 6 shows a schematic diagram illustrating a fourth exemplary implementation of the power balancing system in the audio system of Fig. 1B. In this example, the prior art system with the shared booster as shown in Fig. 1B is modified. Each of the audio amplifier circuits 510a, 501b is modified with a power balancing system 1200a, 1200b. Compared to Fig. 1B, the second audio amplifier circuit 510b in Fig. 6 integrates a second inductor L2, enabling direct power supply from source 532 to both boost converters 512a, 512b. In this implementation, both boost converters 512a, 512b operate and are connected in parallel, enabling summation of power supply to the first and/or second amplifiers 514a, 514b.

In this example, the signal providing an indication of the target boosting power may be a gain signal. A first maximum detector 515a is responsible of detecting a maximum gain between a primary gain 511a and a secondary gain 513a in the first audio amplifier circuit 510a. Similarly, a second maximum detector 515b is responsible of detecting a maximum gain between a primary gain 511b and a secondary gain 513b in the second audio amplifier circuit 510b. In the first audio amplifier circuit 510a, a value of the secondary gain 513a may be equal to a value of the primary gain 511b of the second audio amplifier circuit 510b. For example, as in Fig. 1B, when the power needs of the second amplifier 514b surpasses the capacity of the second boost converter 512b, the value of the incoming secondary gain 513a to the first maximum detector 515a is made equal to the value of the primary gain 511b of the second amplifier 514b. However, unlike the situation in Fig. 1B, where only the first boost converter 12a provides the full power, both boost converters 512a, 512b now operate together to provide power to the second amplifier 514b. This collaborative action sums the current limits of the boost converters 512a, 512b and give the freedom to use the power in just one amplifier or distribute it over the two amplifiers 514a, 514b. Furthermore, this diminishes the dimensions of the coil L1 and the load on each of the boost converters 512a, 512b. This implementation is best suitable for audio systems with a small amount of boost converters, since the maximum detectors 515a, 515b need to have at least the same number of inputs as boost converters 512a, 512b. The maximum detectors 515a, 515b may be implemented by using comparators or one or more processors.

The present disclosure may be exemplified or embodied in other specific forms without departing from its essential characteristics. The described examples are to be considered in all respects only as illustrative and not restrictive to the inventive concept. The scope of the disclosure is, therefore, indicated by the appended claims rather than by the foregoing description. It will be apparent to the person skilled in the art that alternative and equivalent examples of the disclosure can be conceived and reduced to practice. In addition, many modifications may be made to adapt a particular configuration or material to the teachings of the disclosure without departing from the essential scope thereof. All modifications which come within the meaning and range of equivalency of the claims are to be embraced within their scope.

## Claims

1. An audio amplifier circuit comprising:
an amplifier; and
a power balancing system comprising an interface circuit for connection to one or more other interface circuits of one or more other audio amplifier circuits, and a power terminal for connection to one or more other power terminals of the one or more other audio amplifier circuits thereby enabling power transfer between the audio amplifier circuit and the one or more other amplifier circuits, the power balancing system configured to:
receive a signal providing an indication of a target boosting power, wherein the target boosting power is determined based on power needs of the amplifier, and
obtain, at the interface circuit, a maximum signal providing an indication of a maximum boosting power among the signal and one or more other signals indicating other target boosting powers corresponding respectively to the one or more other audio amplifier circuits, wherein each of the one or more other amplifier circuits comprises other amplifier, and each of the one or more other target boosting powers is respectively determined based on power needs of the other amplifier of the corresponding one or more other audio amplifier circuits;
wherein the audio amplifier circuit and/or at least one of the one or more other audio amplifier circuits comprises a boost converter to be adjusted with the maximum signal to deliver the maximum boosting power.

2. The audio amplifier circuit of claim 1, wherein the audio amplifier circuit comprises the boost converter, the boost converter is configured to deliver the maximum boosting power to the amplifier and to the power terminal, and the power balancing system is further configured to:
transfer the maximum boosting power from the boost converter to the one or more other amplifier circuits through the power terminal;
wherein one or more of the other audio amplifier circuits comprises other boost converter, each of the other boost converters is configured to deliver the maximum boosting power to the other amplifier and the other power terminal of the corresponding other audio amplifier circuit, and the power balancing system is further configured to:
receive the maximum boosting power from the one or more of the other audio amplifier circuits comprising other boost converter, through the power terminal.

3. The audio amplifier circuit of claim 1 or claim 2, wherein the audio amplifier circuit comprises a boost converter, the audio amplifier circuit further comprises a power input connected to a power source through a booster inductor, and wherein if one or more of the other audio amplifier circuits comprises other boost converter, each of these other audio amplifier circuits further comprises other power input connected to the power source through other booster inductor, wherein the power source is configured for supplying power to the audio amplifier circuit and the other audio amplifier circuits and wherein phase shifts are incorporated between the boost converter and the other boost converters to achieve low ripple current.

4. The audio amplifier circuit of any preceding claim, wherein the audio amplifier circuit comprises a boost converter, the boost converter includes an inductor and a capacitor; and wherein if one or more of the other audio amplifier circuits comprises other boost converter, each of the other boost converters respectively includes other inductor and other capacitor, wherein values of the inductor and the other inductors and values of the capacitor and the other capacitors are nearly identical among the boost converter and the other boost converters such that the power supplied by the power source is equally distributed among the boost converter and the other boost converters.

5. The audio amplifier circuit of any preceding claim, wherein the target boosting power is further determined based on a digital audio signal to be amplified by the amplifier, and wherein each of the other target boosting powers is further determined based on other digital audio signal to be amplified by the other amplifier of the corresponding other audio amplifier circuit.

6. The audio amplifier circuit of claim 5, further comprising an audio bus configured for conveying the digital audio signal to be amplified from an external processor to the audio amplifier circuit, wherein each of the other audio amplifier circuits comprises other audio bus configured for conveying the other digital audio signal to be amplified from the external processor, or other external processor, to the other audio amplifier circuit.

7. The audio amplifier circuit of any preceding claim, further comprising a speaker connected to the amplifier, wherein the amplifier has feedback to adapt to the load of the speaker; and wherein the one or more other audio amplifier circuits each comprises other speaker respectively connected to the other amplifier of the corresponding other audio amplifier circuit, with the other amplifier having feedback to adapt to the load of the respective other speaker.

8. The audio amplifier circuit of any of the claims 5-7, wherein the signal providing an indication of the target boosting power is a digital set-point representing the target boosting power, wherein the audio amplifier circuit further comprises a boost control circuit configured for generating the digital set-point from the digital audio signal, and to provide the digital set-point to the power balancing system; wherein each other signal providing an indication of the other target boosting power is other digital set-point representing the other target boosting power, wherein each of the other audio amplifier circuits further comprises other boost control circuit each configured for generating the other digital set-point representing the other target boosting power from the other digital audio signal and to provide the other digital set-point to the power balancing system.

9. The audio amplifier circuit of claim 8, wherein the interface circuit comprises a Digital to PWM converter configured for converting the digital set-point to a PWM signal and a transistor with an Open Drain Output, wherein the Gate terminal of the transistor receives the PWM signal and the Drain terminal is connected to an interface line and to the ground via a resistor; and wherein each of the other audio amplifier circuits comprises other Digital to PWM converter configured for converting the other digital set-point to other PWM signal, and other transistor with other Open Drain Output, wherein the Gate terminal of the other transistor receives the other PWM signal and the Drain terminal is connected to the interface line and to the ground via other resistor;
wherein the power balancing system obtains the maximum boosting power by detecting, at the interface circuit, a highest PWM duty-cycle signal among the PWM signal and the other PWM signals;
wherein if the audio amplifier circuit comprises a boost converter, the power balancing system further comprises a PWM to Digital converter configured for converting the highest PWM duty-cycle signal to the maximum digital set-point representing the maximum boosting power.

10. The audio amplifier circuit of claim 8, wherein the interface circuit further comprises a Digital to Analogue Converter configured for converting the digital set-point to an analogue signal, an Op-Amp circuit configured for receiving the analogue signal and outputting an amplified analogue signal , and a transistor with an Open Drain Output wherein the Gate terminal of the transistor receives the analogue signal and the Drain terminal is connected to an interface line and to the ground via a resistor; wherein each of the other audio amplifier circuits comprises other Digital to Analogue Converter configured for converting the other digital set-point to other analogue signal, other Op-Amp circuit configured for receiving the other analogue signal and outputting other amplified analogue signal and other transistor with an Open Drain Output, wherein the Gate terminal of the other transistor, receives the other analogue signal and the Drain terminal is connected to the interface line and to the ground via other resistor;
wherein the power balancing system obtains the maximum boosting power by detecting, at the interface circuit, a maximum analogue signal among the analogue signal and the other analogue signals;
wherein if the audio amplifier circuit comprises a boost converter, the power balancing system further comprises an Analogue to Digital Converter configured for converting the maximum analogue signal to the maximum digital set-point representing the maximum boosting power.

11. The audio amplifier circuit of claim 9 or claim 10, wherein the transistor is a N-channel MOSFETs or a NPN bipolar junction transistor.

12. The audio amplifier circuit of claim 8, wherein the interface circuit comprises a processor configured as a maximum digital set-point detector and configured to:
receive the digital set-point and the other digital set-points,
determine the maximum digital set-point representing the maximum boosting power, and
adjust the boost converter by providing the boost converter with the maximum digital set-point.

13. The audio amplifier circuit of any preceding claim, wherein the boost converter and the other boost converters, if present, are step-up DC-DC converters able to work in discontinuous mode, and when an output voltage of the step-up DC-DC converter reaches or exceeds a voltage related to the target boosting power, the step-up DC-DC converters stop switching resulting in zero or negative current flowing through the inductor in the step-up DC-DC converter and energy stored in the inductor is gradually dissipated.

14. The audio amplifier circuit of any preceding claim, wherein the amplifier and the other amplifiers are class-D switching amplifiers.

15. An audio system comprising at least two audio amplifier circuits according to any of the preceding claims, wherein each audio amplifier circuit comprises at least one amplifier requiring a target boosting power, wherein at least one audio amplifier circuit comprises a boost converter and wherein the power balancing system in the audio amplifier circuit comprising the boost converter is configured to obtain a maximum boosting power among the target boosting powers of the amplifiers of the at least two audio amplifier circuits, and adjust the boost converter to provide the maximum boosting power.

## Amended claims

### Amended claims in accordance with Rule 137(2) EPC.

1. An audio amplifier circuit comprising:
an amplifier; and
a power balancing system comprising an interface circuit configured to connect to one or more other interface circuits, through an interface line, of one or more other audio amplifier circuits, and a power terminal for connection to one or more other power terminals of the one or more other audio amplifier circuits thereby enabling power transfer between the audio amplifier circuit and the one or more other amplifier circuits, the power balancing system configured to:
receive a signal providing an indication of a target boosting voltage, wherein the target boosting voltage is determined based on power needs of the amplifier, and
obtain, at the interface circuit, a maximum signal providing an indication of a maximum boosting voltage among the signal and one or more other signals indicating other target boosting voltages corresponding respectively to the one or more other audio amplifier circuits, wherein each of the one or more other amplifier circuits comprises other amplifier, and each of the one or more other target boosting voltage is respectively determined based on power needs of the other amplifier of the corresponding one or more other audio amplifier circuits;
wherein at least one of the audio amplifier circuit and the one or more other audio amplifier circuits comprises a boost converter to be adjusted with the maximum signal to deliver the maximum boosting voltage.

2. The audio amplifier circuit of claim 1, wherein the audio amplifier circuit comprises the boost converter, the boost converter is configured to deliver the maximum boosting voltage to the amplifier and to the power terminal, and the power balancing system is further configured to:
transfer the maximum boosting voltage from the boost converter to the one or more other amplifier circuits through the power terminal;
wherein one or more of the other audio amplifier circuits comprises other boost converter, each of the other boost converters is configured to deliver the maximum boosting voltage to the other amplifier and the other power terminal of the corresponding other audio amplifier circuit, and the power balancing system is further configured to:
receive the maximum boosting voltage from the one or more of the other audio amplifier circuits comprising other boost converter, through the power terminal.

3. The audio amplifier circuit of claim 1 or claim 2, wherein the audio amplifier circuit comprises a boost converter, the audio amplifier circuit further comprises a power input connected to a power source through a booster inductor, and wherein if one or more of the other audio amplifier circuits comprises other boost converter, each of these other audio amplifier circuits further comprises other power input connected to the power source through other booster inductor, wherein the power source is configured for supplying power to the audio amplifier circuit and the other audio amplifier circuits and wherein phase shifts are incorporated between the boost converter and the other boost converters to achieve low ripple current.

4. The audio amplifier circuit of any preceding claim, wherein the audio amplifier circuit comprises a boost converter, the boost converter includes an inductor and a capacitor; and wherein if one or more of the other audio amplifier circuits comprises other boost converter, each of the other boost converters respectively includes other inductor and other capacitor, wherein values of the inductor and the other inductors and values of the capacitor and the other capacitors are nearly identical among the boost converter and the other boost converters such that the power supplied by the power source is equally distributed among the boost converter and the other boost converters.

5. The audio amplifier circuit of any preceding claim, wherein the target boosting voltage is further determined based on a digital audio signal to be amplified by the amplifier, and wherein each of the other target boosting voltages is further determined based on other digital audio signal to be amplified by the other amplifier of the corresponding other audio amplifier circuit.

6. The audio amplifier circuit of claim 5, further comprising an audio bus configured for conveying the digital audio signal to be amplified from an external processor to the audio amplifier circuit, wherein each of the other audio amplifier circuits comprises other audio bus configured for conveying the other digital audio signal to be amplified from the external processor, or other external processor, to the other audio amplifier circuit.

7. The audio amplifier circuit of any preceding claim, further comprising a speaker connected to the amplifier, wherein the amplifier has feedback to adapt to the load of the speaker; and wherein the one or more other audio amplifier circuits each comprises other speaker respectively connected to the other amplifier of the corresponding other audio amplifier circuit, with the other amplifier having feedback to adapt to the load of the respective other speaker.

8. The audio amplifier circuit of any of the claims 5-7, wherein the signal providing an indication of the target boosting voltage is a digital set-point representing the target boosting voltage, wherein the audio amplifier circuit further comprises a boost control circuit configured for generating the digital set-point from the digital audio signal, and to provide the digital set-point to the power balancing system; wherein each other signal providing an indication of the other target boosting voltage is other digital set-point representing the other target boosting voltage, wherein each of the other audio amplifier circuits further comprises other boost control circuit each configured for generating the other digital set-point representing the other target boosting voltage from the other digital audio signal and to provide the other digital set-point to the power balancing system.

9. The audio amplifier circuit of claim 8, wherein the interface circuit comprises a Digital to PWM converter configured for converting the digital set-point to a PWM signal and a transistor with an Open Drain Output, wherein the Gate terminal of the transistor receives the PWM signal and the Drain terminal is connected to an interface line and to the ground via a resistor; and wherein each of the other audio amplifier circuits comprises other Digital to PWM converter configured for converting the other digital set-point to other PWM signal, and other transistor with other Open Drain Output, wherein the Gate terminal of the other transistor receives the other PWM signal and the Drain terminal is connected to the interface line and to the ground via other resistor;
wherein the power balancing system obtains the maximum boosting voltage by detecting, at the interface circuit, a highest PWM duty-cycle signal among the PWM signal and the other PWM signals;
wherein if the audio amplifier circuit comprises a boost converter, the power balancing system further comprises a PWM to Digital converter configured for converting the highest PWM duty-cycle signal to the maximum digital set-point representing the maximum boosting voltage.

10. The audio amplifier circuit of claim 8, wherein the interface circuit further comprises a Digital to Analogue Converter configured for converting the digital set-point to an analogue signal, an Op-Amp circuit configured for receiving the analogue signal and outputting an amplified analogue signal , and a transistor with an Open Drain Output wherein the Gate terminal of the transistor receives the analogue signal and the Drain terminal is connected to an interface line and to the ground via a resistor; wherein each of the other audio amplifier circuits comprises other Digital to Analogue Converter configured for converting the other digital set-point to other analogue signal, other Op-Amp circuit configured for receiving the other analogue signal and outputting other amplified analogue signal and other transistor with an Open Drain Output, wherein the Gate terminal of the other transistor, receives the other analogue signal and the Drain terminal is connected to the interface line and to the ground via other resistor;
wherein the power balancing system obtains the maximum boosting voltage by detecting, at the interface circuit, a maximum analogue signal among the analogue signal and the other analogue signals;
wherein if the audio amplifier circuit comprises a boost converter, the power balancing system further comprises an Analogue to Digital Converter configured for converting the maximum analogue signal to the maximum digital set-point representing the maximum boosting voltage.

11. The audio amplifier circuit of claim 9 or claim 10, wherein the transistor is a N-channel MOSFETs or a NPN bipolar junction transistor.

12. The audio amplifier circuit of claim 8, wherein the interface circuit comprises a processor configured as a maximum digital set-point detector and configured to:
receive the digital set-point and the other digital set-points,
determine the maximum digital set-point representing the maximum boosting voltage, and
adjust the boost converter by providing the boost converter with the maximum digital set-point.

13. The audio amplifier circuit of any preceding claim, wherein the boost converter and the other boost converters, if present, are step-up DC-DC converters able to work in discontinuous mode, and when an output voltage of the step-up DC-DC converter reaches or exceeds a voltage related to the target boosting voltage, the step-up DC-DC converters stop switching resulting in zero or negative current flowing through the inductor in the step-up DC-DC converter and energy stored in the inductor is gradually dissipated.

14. The audio amplifier circuit of any preceding claim, wherein the amplifier and the other amplifiers are class-D switching amplifiers.

15. An audio system comprising at least two audio amplifier circuits according to any of the preceding claims, wherein each audio amplifier circuit comprises at least one amplifier requiring a target boosting voltage, wherein at least one audio amplifier circuit comprises a boost converter and wherein the power balancing system in the audio amplifier circuit comprising the boost converter is configured to obtain a maximum boosting voltage among the target boosting voltage s of the amplifiers of the at least two audio amplifier circuits, and adjust the boost converter to provide the maximum boosting voltage.
